# FASCICULE DE BREVET EUROPEEN

(11) **EP 1 271 698 B1**
(45) Date de publication et mention de la délivrance du brevet: **14.07.2004**
(21) Numéro de dépôt: 02100709.1
(22) Date de dépôt: 13.06.2002
(51) Int. Cl.: H01R 12/24

(54) **Ensemble connecteur modulaire pour avionique**
Modulverbindungseinrichtung für Luftfahrtanwendung
Module connector device for avionics industry

(30) Priorité: 21.06.2001 FR 0108218
(43) Date de publication de la demande: 02.01.2003
(73) Titulaire: FCI, 75009 Paris (FR)
(72) Inventeur: Bardet, Laurent, 72000, Le Mans (FR); Jollivet, Franck, 72000, Le Mans (FR)
(74) Mandataire: Schmit, Christian Norbert Marie

(56) Documents cités:
- EP-A- 0 001 555
- DE-A- 3 920 232
- US-A- 5 409 384
- US-A- 5 445 526
- US-A- 5 501 612

## Description

L'invention a pour objet un ensemble connecteur modulaire. Elle trouve plus particulièrement son utilisation dans des ensembles connecteurs soumis à des conditions climatiques et mécaniques difficiles, notamment dans le domaine le domaine de l'avionique, par exemple à l'intérieur d'un calculateur prévu pour un équipement d'avion. L'intérêt de l'invention est de présenter un ensemble connecteur facile à réaliser et à assembler, proposant également une grande flottabilité entre des module de cet ensemble. La maintenance d'un calculateur comportant un ensemble connecteur selon l'invention est facilitée.

Le document DE-A-3 920 232 décrit un ensemble connecteur selon le préambule de la revendication 1.

Dans l'état de la technique, pour assurer une connexion entre un connecteur et une carte de circuit imprimé, on prévoit par exemple de connecter directement des picots du connecteur sur le circuit imprimé. Dans ce cas, lorsque cet ensemble est ainsi connecté, s'il est soumis à des fortes vibrations, le système risque de se défaire étant donnée l'absence de flexibilité de cette connexion. Dans l'état de la technique, on prévoit donc un circuit imprimé flexible entre la carte de circuit imprimé et ce connecteur.

La présence d'un circuit imprimé flexible est nécessaire dans ce type d'ensemble connecteur. En effet, si l'un de ces éléments de l'ensemble connecteur est soumis à des vibrations ou tout autre type de sollicitations, celles-ci ne sont alors pas transmises du connecteur à la carte ou réciproquement. En effet, le circuit imprimé flexible absorbe ces vibrations.

Cependant, dans l'état de la technique, pour connecter un tel circuit imprimé flexible entre le connecteur et la carte du circuit imprimé, on met en oeuvre un premier connecteur sur une première extrémité du circuit flexible, pour assurer une connexion avec un connecteur complémentaire disposé sur la carte de circuit imprimé. D'autre part, on présente un deuxième connecteur sur ce même circuit imprimé flexible pour assurer une deuxième connexion avec le connecteur initial. Ainsi, la connexion souple d'un connecteur initial avec une carte de circuit imprimé met en oeuvre deux connecteurs intermédiaires montés sur un circuit imprimé flexible. De plus, ces connecteurs intermédiaires doivent être respectivement compatibles avec le premier connecteur et respectivement avec la carte de circuit imprimé.

Par exemple, on connaît un montage comportant un connecteur initial, par exemple du type ARINC 600, relié à un circuit imprimé flexible par l'intermédiaire d'un premier connecteur intermédiaire. Ce premier connecteur intermédiaire est par exemple du type PGA (Pin Grid Array). Il correspond alors à une plaque présentant des contacts selon une géométrie particulière, orthogonalement à un plan servant de support à l'ensemble de ces contacts. D'un premier coté de ce plan, les contacts sont reliés au connecteur initial, alors que du deuxième coté de ce plan, les contacts sont reliés avec le circuit imprimé flexible. Pour assurer la connexion entre le connecteur initial et la carte du circuit imprimé, le circuit imprimé flexible est relié ensuite au niveau d'une deuxième portion à un deuxième connecteur intermédiaire. Ce connecteur est lui-même monté sur la carte de circuit imprimé. Il y a dans ce cas quatre niveaux de connexion.

Une telle solution, même si elle comporte un circuit imprimé flexible pose un problème. En effet, le montage de cet ensemble connecteur est complexe et coûte cher, étant donné le nombre d'éléments mis en oeuvre. En effet, pour relier le connecteur à la carte de circuit imprimé, il y a deux connecteurs intermédiaires et un circuit imprimé flexible. Un tel assemblage est difficile à maintenir dans l'état. En effet, toute opération de maintenance doit nécessiter le démontage intégral de chacun des connecteurs intermédiaires et du circuit imprimé flexible. De plus, les connecteurs intermédiaires sont de préférence soudés et rigides. Notamment, ils sont disposés sur le circuit imprimé flexible de manière inamovible. Il est donc impossible d'assurer une opération de maintenance sans les endommager

L'invention a pour objet de remédier au problème cité en proposant un connecteur modulaire comportant moins d'éléments intermédiaires pour assurer la connexion entre un connecteur initial et une carte de circuit imprimé. De plus, l'ensemble connecteur selon l'invention permet une maintenance facilitée. Aucun des éléments de cet ensemble connecteur n'est endommagé lors d'un démontage éventuel, car chaque élément est monté de manière réversible.

La solution apportée par l'invention comporte un connecteur et une carte de circuit imprimé. Le connecteur est relié à la carte de circuit imprimé par l'intermédiaire d'un circuit imprimé flexible et d'un unique connecteur intermédiaire disposé sur la carte de circuit imprimé. Il n'y a donc que trois niveaux de connexion. En effet, sur une première portion du circuit imprimé flexible, il présente des contacts pouvant être connectés avec des contacts du connecteur complémentaire monté sur la carte de circuit imprimé. Le circuit imprimé flexible comporte une deuxième portion directement connectable avec le connecteur. Ceci constitue un deuxième niveau de connexion entre la carte et ce connecteur. En effet, le troisième et dernier niveau de connexion est réalisé entre le connecteur intermédiaire et la carte de circuit imprimé.

L'avantage présenté par l'invention est de proposer également moins de niveaux de connexion entre le connecteur et la carte de circuit imprimé. La maintenance d'un tel ensemble connecteur est un souci majeur. En effet, ce type d'ensemble connecteur est soumis à des conditions climatiques et environnementales (vibrations, chocs) très rudes et donc voit apparaître de nombreuses pannes. De plus, dans un avion, les conditions climatiques sont fortement instables. Ainsi, avant un départ, pendant une phase de stationnement d'un avion, on peut avoir une température supérieure à +60° C. Pendant un vol, la température décroît jusqu'à une valeur de l'ordre de -50° C. A l'atterrissage la température peut être de + 40° C par exemple. Ces variations de températures importantes créent donc des conditions de fonctionnement difficiles pour les éléments de l'ensemble connecteur modulaire, entraînant un risque de pannes. L'invention présente donc l'avantage majeur de faciliter les opérations de maintenance en diminuant le nombre d'interconnexions entre les éléments de l'ensemble connecteur.

L'invention concerne un ensemble connecteur modulaire comportant un premier connecteur monté sur une carte de circuit imprimé, et un deuxième connecteur relié au premier connecteur par le biais d'un circuit imprimé flexible, caractérisé en ce que le circuit imprimé flexible comporte une première portion munie de contacts pour coopérer avec des contacts montés sur la carte de circuit imprimé, et une deuxième portion comportant des orifices pour coopérer avec des broches du deuxième connecteur.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1 : une vue de dessus éclatée d'un ensemble connecteur modulaire selon l'invention ;
- Figure 2 : une vue en coupe d'un premier mode de réalisation d'une première portion d'un circuit imprimé flexible de l'ensemble connecteur selon l'invention ;
- Figure 3 : une vue en coupe d'une carte de circuit imprimé d'un ensemble connecteur selon l'invention ;
- Figure 4 : une vue en coupe d'un deuxième mode de réalisation de la première portion du circuit imprimé flexible selon l'invention ;
- Figure 5 : une vue en coupe d'un troisième mode de réalisation de la première portion du circuit imprimé flexible ;
- Figure 6: une vue de profil d'un ensemble connecteur modulaire comportant deux cartes de circuit imprimé ;
- Figure 7 : une vue en coupe de l'ensemble connecteur selon la figure 6.

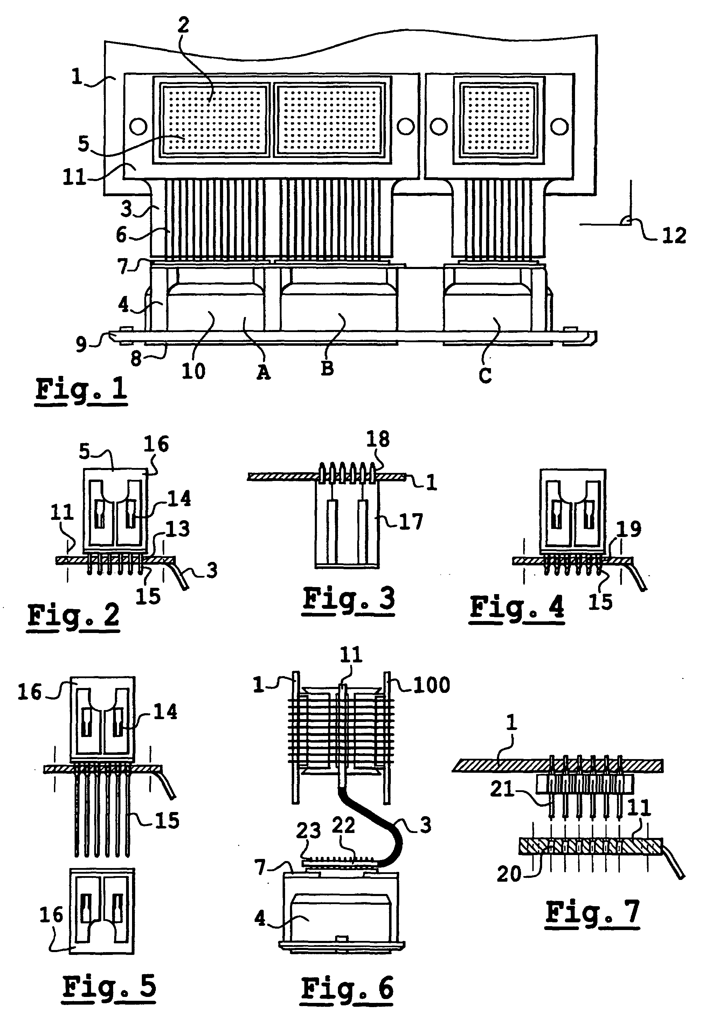

La figure 1 montre un ensemble connecteur modulaire selon l'invention. L'ensemble comporte une carte de circuit imprimé 1 sur laquelle est monté un premier connecteur 2. Ce premier connecteur 2 est un connecteur intermédiaire. Il est relié à un circuit imprimé flexible 3. Le circuit imprimé flexible 3 est lui-même relié à un deuxième connecteur 4. Ainsi la carte 1 est reliée au deuxième connecteur 4.

La carte de circuit imprimé 1 est prévue pour être intégrée à l'intérieur d'un calculateur, par exemple dans un équipement pour l'avionique.

Le premier connecteur 2 est par exemple du type des connecteurs de deux millimètres de large standardisés. Il comporte au moins un contact 5 relié respectivement avec les contacts complémentaires de la carte de circuit imprimé 1. Dans un mode de réalisation préféré, le connecteur 2 comporte cent cinquante contacts répartis selon une géométrie classique, à l'intérieur d'une cavité. Ces contacts sont par exemple réparti de manière homogène selon plusieurs lignes et plusieurs colonnes. Les différents contacts 5 sont reliés respectivement à des pistes conductrices 6 du circuit imprimé flexible 3. Ainsi, on a une connexion entre les contacts de la carte de circuit imprimé 1 et le circuit imprimé flexible 3. Le circuit imprimé flexible 3 est par exemple un circuit multicouche.

Les pistes 6 du circuit imprimé flexible 3 sont reliées au deuxième connecteur 4 directement. Ce deuxième connecteur 4 présente une face arrière 7 au niveau de laquelle les pistes 6 sont connectées, et une face avant 8. La face avant 8 présente un support métallique rigide 9. Le support 9 encadre des contacts (non représentés) de ce deuxième connecteur 4. Le deuxième connecteur 4 est prévu pour recevoir un connecteur complémentaire au niveau de cette face avant 8. De préférence, les contacts du deuxième connecteur 4 sont protégés dans un boîtier 10 à l'arrière de la face avant 8 et de la plaque rigide 9. Ainsi, le deuxième connecteur 4 permet d'assurer une connexion entre les pistes 6 du circuit imprimé flexible 3 et les contacts de ce deuxième connecteur 4.

On obtient ainsi une connexion entre la carte de circuit imprimé 1 et ce deuxième connecteur 4.

Le circuit imprimé flexible 3 comporte une première portion 11 au niveau de laquelle sont présentés les contacts 5. Cette première portion 11 est de préférence présentée parallèlement à un plan 12 formé par la carte de circuit imprimé 1. Par ailleurs, ce circuit imprimé flexible comporte une deuxième portion, de préférence orientée orthogonalement à ce plan 12. Cette deuxième portion est présentée parallèlement à la face arrière 7 du deuxième connecteur 4.

De plus, la face avant 8 de connexion est de préférence également orthogonale au plan 12. Le support 9 est de préférence monté au niveau d'une ouverture d'un boîtier dans lequel est disposée la carte de circuit imprimée 1. La face avant 8 sert alors d'interface entre l'extérieur de ce boîtier et le circuit imprimé 1. Ainsi, dans la mesure où le boîtier est soumis à des vibrations, étant donné les conditions environnementales liées à son emplacement dans un avion, les vibrations ne sont pas directement transmises à la carte de circuit imprimée grâce au circuit imprimé flexible.

À la figure 2, un premier mode de réalisation de la première portion 11 est représenté. La première portion 11 est reliée au circuit imprimé flexible 3. Elle présente notamment des contacts 5 tels que ces contacts 5 comportent des picots 13 traversant la portion 11 et comportant une première extrémité 14 pour être connectés avec des contacts complémentaires. Le contact 13 comporte une deuxième extrémité 15, d'un deuxième coté de la première portion 11, pour être retenu par cette première portion 11. Les premières extrémités 14 de ce contact 5 sont par exemple protégées dans un boîtier semi-ouvert 16. Ce boîtier 16 sert de rail de guidage pour un boîtier complémentaire 17 présenté figure 3, le boîtier complémentaire protégeant des contacts complémentaires 18 du circuit imprimé 1.

Dans un autre mode de réalisation, les deuxièmes extrémités 15 sont longues, plates et recourbées et éventuellement soudées du deuxième côté de la première portion 11.

Dans une variante, présentée figure 4, ces deuxièmes extrémités 15 sont par exemple des picots à insérer en force dans la première portion 11. Dans cette variante, les deuxièmes extrémités 15 comportent alors une forme bombée 19 (contact press-fit pour insertion en force) au niveau des trous de la première portion 11 dans lesquels elles sont respectivement insérées. Cette forme bombée 19 du picot est retenue dans la première portion 11, car elle présente un diamètre extérieur légèrement supérieur au diamètre intérieur du trou dans lequel elle est insérée.

Dans une deuxième variante, Figure 5, la première extrémité 14 et les deuxièmes extrémités 15 de chacun des contacts 13 dépassent suffisamment de part et d'autre de la première portion 11 de manière à pouvoir venir se connecter avec des contacts complémentaires présentés respectivement de chacun des cotés. Dans ce cas, chaque contact 13 comporte une forme bombée telle que 19 au niveau de chaque trou de la première portion 11. La forme bombée 19 est insérée et retenue dans cette première portion 11. De plus, dans ce deuxième mode de réalisation, on peut disposer deux boîtiers de guidage tel que 16 de part et d'autre de cette première portion 11 pour protéger chacune de ces extrémités 14 et respectivement 15. Avec une première portion telle que décrite dans ce deuxième mode de réalisation, on peut par exemple relier le deuxième boîtier 4 à deux circuits imprimés 1 et 100 telle que présenté figure 6. Dans ce cas, la première portion 11 est disposée entre ces deux circuits imprimés 1 et 100.

Selon un autre mode de réalisation, la première portion 11, Figure 7, comporte des douilles femelles 20. Ces douilles femelles 20 sont prévues pour recevoir des picots 21 présentés et retenus sur le circuit imprimé 1.

Les deuxièmes connecteurs A et B peuvent néanmoins être réparés au moins partiellement indépendamment l'un de l'autre, dans la mesure où le circuit imprimé flexible comporte une fente. Cette fente est formée entre les connecteurs A et B.

Dans un mode de réalisation préféré, la carte de circuit imprimée 1 est prévue pour être connectée à trois connecteurs tel que 4. Dans ce cas, on prévoit par exemple un premier connecteur A, un deuxième connecteur B et un troisième connecteur C. Les connecteurs A et B sont par exemple reliés à un même circuit imprimé flexible tel que 3 pour être reliés complètement à deux connecteurs intermédiaires juxtaposés tels que 2 du circuit imprimé 1. Parallèlement, le troisième connecteur C est relié par un deuxième circuit imprimé flexible indépendant à un troisième connecteur intermédiaire tel que 2 sur ce même circuit imprimé 1. Dans ce cas, on peut avoir une maintenance différenciée entre celle dédiée au connecteur C à celle dédiée aux connecteurs A et B. Dans cet exemple, les connecteurs A et B comportent chacun 150 points de connexion, et le connecteur C comporte 100 points de connexion.

Le deuxième connecteur 4 est relié au circuit imprimé flexible 3 par une deuxième portion 22 Figure 6. La deuxième portion 22 comporte de préférence des orifices (non représentés) traversés par des broches 23 présentées au niveau de la face arrière 7 de ce deuxième connecteur 4. Ainsi, on obtient une connexion sans intermédiaire du circuit imprimé flexible 3 avec le deuxième connecteur 4. Dans un mode de réalisation particulier, les broches 23 sont de préférence des broches insérées en force dans les orifices de la deuxième portion 22. Ainsi, la rétention du circuit imprimé flexible 3 est assurée sur le deuxième connecteur.

## Revendications

1. Ensemble connecteur modulaire comportant un premier connecteur (2) monté sur une carte de circuit imprimé (1), et un deuxième connecteur (4) relié au premier connecteur par le biais d'un circuit imprimé flexible (3), le circuit imprimé flexible comportant une première portion (11) munie de contacts mâles (5) pour coopérer avec des contacts (18) montés sur la carte de circuit imprimé, les contacts mâles comportant des picots (13), chaque picot comportant une première extrémité (14) dépassant d'un premier côté du circuit imprimé flexible, et une deuxième extrémité (15) dépassant d'un deuxième côté du circuit imprimé flexible, **caractérisé en ce que** ces deux extrémités peuvent chacune coopérer avec des contacts complémentaires, et **caractérisé en ce que** le circuit imprimé flexible comporte une deuxième portion (22) comportant des orifices pour coopérer avec des broches (23) du deuxième connecteur.

2. Ensemble connecteur selon la revendication 1 **caractérisé en ce que** les contacts mâles sont des picots (13) à souder.

3. Ensemble connecteur selon l'une des revendications 1 à 2 **caractérisé en ce que** les contacts mâles sont des picots à insérer en force, et présentent une forme bombée (19) pour être comprimés respectivement dans des trous de la première portion.

4. Ensemble connecteur selon l'une des revendications 1 à 3 caractérisé en ce les contacts complémentaires sont disposés sur des cartes de circuit imprimé (1, 100).

5. Ensemble connecteur selon l'une des revendications 1 à 4 **caractérisé en ce que** le deuxième connecteur est du type ARINC 600, et présente par exemple une face de connexion (8) pour recevoir un troisième connecteur complémentaire.

6. Ensemble connecteur selon l'une des revendications 1 à 5 **caractérisé en ce que** la carte de circuit imprimé est reliée à plusieurs deuxième connecteurs (A, B, C) par l'intermédiaire de plusieurs circuit imprimé flexible.

7. Ensemble connecteur selon l'une des revendications 1 à 6 **caractérisé en ce que** les broches du deuxième connecteur sont insérées en force dans les orifices du circuit imprimé flexible.

## Patentansprüche

1. Modulares Steckverbindersystem mit einem ersten auf einer starren Leiterplatte (1) montierten Steckverbinder (2) und einem zweiten Steckverbinder (4), der über eine flexible Leiterplatte (3) mit dem ersten Steckverbinder verbunden ist, wobei die flexible Leiterplatte einen ersten Abschnitt (11) aufweist, welcher mit Steckkontakten (5) versehen ist, die mit auf der starren Leiterplatte angebrachten Kontakten (18) in Eingriff bringbar sind, wobei die Steckkontakte Stifte (13) aufweisen mit jeweils einem ersten Ende (14), das auf einer ersten Seite aus der flexiblen Leiterplatte herausragt, und einem zweitem Ende (15), das auf einer zweiten Seite aus der flexiblen Leiterplatte herausragt,
**dadurch gekennzeichnet, dass**
diese beiden Enden jeweils mit entsprechenden Kontakten in Eingriff bringbar sind und **dadurch gekennzeichnet, dass** die flexible Leiterplatte einen zweiten Abschnitt (22) aufweist, welcher mit Öffnungen versehen ist, die mit Anschlussbeinen (23) des zweiten Steckverbinders zusammenwirken.

2. Steckverbindersystem nach Anspruch 1, **dadurch gekennzeichnet, dass** die Steckkontakte Lötstifte (13) sind.

3. Steckverbindersystem nach einem der Ansprüche 1 bis 2, **dadurch gekennzeichnet, dass** die Steckkontakte Einpressstifte sind, die durch mechanischen Druck eingesetzt werden und eine ausgewölbte Form (19) aufweisen, so dass sie jeweils in im ersten Abschnitt vorgesehene Löcher eingepresst werden können.

4. Steckverbindersystem nach einem der Ansprüche 1 bis 3, **dadurch gekennzeichnet, dass** die entsprechenden Kontakte auf starren Leiterplatten (1, 100) angeordnet sind.

5. Steckverbindersystem nach einem der Ansprüche 1 bis 4, **dadurch gekennzeichnet, dass** der zweite Steckverbinder ein Steckverbinder des Typs ARINC 600 ist und beispielsweise eine Anschlussseite (8) zur Aufnahme eines dritten entsprechenden Steckverbinders aufweist.

6. Steckverbindersystem nach einem der Ansprüche 1 bis 5, **dadurch gekennzeichnet, dass** die starre Leiterplatte über mehrere flexible Leiterplatten mit mehreren zweiten Steckverbindern (A, B, C) verbunden ist.

7. Steckverbindersystem nach einem der Ansprüche 1 bis 6, **dadurch gekennzeichnet, dass** die Anschlussbeine des zweiten Steckverbinders in die Öffnungen der flexiblen Leiterplatte eingepresst sind.

## Claims

1. A modular connector assembly having a first connector (2) mounted to a printed circuit board (1) and a second connector (4) that is connected to the first connector through a flexible printed circuit (3), said flexible printed circuit comprising a first portion (11) provided with pin contacts (5) for cooperating with contacts (18) mounted to the printed circuit board, the pin contacts comprising pins (13), each pin comprising a first end (14) that projects from a first side of the flexible printed circuit and a second end (15) that projects from a second side of the flexible printed circuit,
**characterized in that**
said two ends are both capable of cooperating with complementary contacts and **characterized in that** the flexible printed circuit comprises a second portion (22) having bores for cooperating with connecting pins (23) of the second connector.

2. The connector assembly in accordance with claim 1, **characterized in that** the pin contacts are solder pins (13).

3. The connector assembly in accordance with any of the claims 1 through 2, **characterized in that** the pin contacts are press fit pins and are formed in a rounded shape (19) for being press fitted into respective holes of the first portion.

4. The connector assembly in accordance with any of the claims 1 through 3, **characterized in that** the complementary contacts are disposed on printed circuit boards (1, 100).

5. The connector assembly in accordance with any of the claims 1 through 4, **characterized in that** the second connector is an ARINC 600 connector and has for example a connection face (8) for receiving a third complementary connector.

6. The connector assembly in accordance with any of the claims 1 through 5, **characterized in that** the printed circuit board is connected to a plurality of second connectors (A, B, C) through a plurality of flexible printed circuits.

7. The connector assembly in accordance with any of the claims 1 through 6, **characterized in that** the connecting pins of the second connector are press fitted into the bores of the flexible printed circuit.
